# EUROPEAN PATENT APPLICATION

(11) **EP 1 840 652 A1**
(43) Date of publication of application: **03.10.2007**
(21) Application number: 06006290.8
(22) Date of filing: 27.03.2006
(51) Int. Cl.: G03F 7/027, G03F 7/00

(54) **Photo-curable resins and resin compositions with very high refractive indices for application in plastic optics**

(71) Applicant: SeeReal Technologies S.A., 1528 Luxembourg (LU)
(72) Inventor: Peng, Bin, 01069 Dresden (DE); Sahm, Hagen, 01307 Dresden (DE)

(57) **Abstract**

Photo-curable resins and resin compositions with very high refractive indices comprising
(a) a naphthylaliphatic acrylate or a naphthylatiphatic methacylate, typically 1-, or 2-naphthylmethyl acrylate, 1-, or 2-naphthylmethyl methacrylate, 1-, or 2-naphthylethyl acrylate, 1-, or 2-naphthylethyl methacrylate, 1-, or 2-naphthylpropyl acryate, 1-, or 2-naphthylpropyl methacrylate, with a weight percent of 60 to 90%, preferably 70 to 80%
(b) an aromatic multiacrylate or an aromatic multimethacrylate, typically 1, 4-hydroquinone diacrylate, 1, 4-hydroquinone dimethacrylate, naphthalene diacrylates or dimethacrylate (e.g., 1, 4-naphthalene diacrylate, 1, 4-naphthalene dimethacrylate, 2, 5-naphthylene diacrylate, 2,5-naphthalene dimethacrylate), with a weight percent of 1 to 10%, preferably 2 to 5%
(c) a multibromated aromatic acrylate or a multibromated aromatic methacrylate, typically 2,3,4,5,6-pentabromophenyl acrylate, 2,3,4,5,6-pentabromobenzyl acrylate, 2,3,4,5,6-pentabromophenyl methacrylate, 2,3,4,5,6-pentabromobenzyl methacrylate, 2,4,6-tribromophenyl acrylate, or 2,4,6-tribromophenyl methacrylate, with a weight percent of 10 to 30%, preferably 15 to 25%
(d) and a photo-initiator, with a weight percent of 0.1 to 5 %, preferably 0,5 to 1,5%.

## Description

### 1 Background

The present invention relates to photo-curable resins and resin compositions with very high refractive indices. Such resins find applications in various optical fields where very high refractive indices of plastic optical elements are required. One example of such elements are optical lenses in general and more particularly lenticular lenses or flat optical masks, which are simply referred as masks within this document.

Due to lower costs, lightweight and the fact that aspherical parts can be manufactured as conveniently as spherical parts with techniques such as inject moulding, compress moulding, or casting, plastic optics is drawing more and more interest both in the academic world and in industry.

The most important properties of optical plastics are the optical properties, i.e. the refractive index and the dispersion (expressed in Abbe number). Refractive index of optical plastics which are industrial available ranges from 1.45 to about 1.61, the corresponding Abbé number roughly from 60 to 25, respectively. The cured polymer has to be optically isotropic. Most of the optical plastics are manufactured with injecting moulding or hot embossing. There are also optical plastics made with UV curing techniques.

Acrylic polymers are among the most used optical plastics. Poly (methyl methacrylate), PMMA, is a typical example of them. The refractive index measured with D-line (nD) of PMMA is 1.49 and the Abbé number 58.

Optical parts made of PMMA can be manufactured both with injecting moulding, hot embossing, starting from polymer pellets, or with UV curing, starting from monomer or resins.

In the practical production and applications, there are, beside the optical properties, additional property demands on the resins and the optical plastic parts, especially with regard to lenticular lenses or masks. Some of these demands are: viscosity of the resin, chemical, mechanical and weathering properties of the plastics. In order to meet these multiple demands to the most satisfactory degrees, usually resins and resin compositions instead of pure monomers are used for fabricating optical plastic parts.

### 2 Prior art

EP 1 484 347 describes a resin composition, which has optical properties such as a high refractive index, has excellent restorability and scratch resistance, and has good adhesion to a substrate, and, when utilized as an optical member (lens) used, for example, in screens for projection televisions or the like, can satisfy various property requirements, and a cured product of the resin composition. The resin composition comprises: an epoxy (meth)acrylate oligomer having an average molecular weight of not more than 1500, a copolymer of a (meth)acrylic ester with styrene or alpha - methylstyrene, a thermoplastic urethane elastomer, a (meth)acrylic ester monomer, and a photopolymerization initiator.

WO 2005 030 833 describes a resin composition which comprises a blend of a polycarbonate and a polyester polymer prepared from a dicarboxylic acid compound and a dihydroxy compound, wherein the dicarboxylic acid compound comprises an alicyclic dicarboxylic acid and/or an ester-formable derivative thereof, and the dihydroxy compound comprises a dihydroxy compound containing a fluorene moiety. The resin composition can be advantageously used for providing a material, which is reduced in double refraction, is excellent in transparency, mechanical strength, dimensional stability, exhibits high thermal resistance, good flowability and offers a good balance of processability and optical characteristics, and thus can be suitably used as an optical material for a camera lens, an eyeglass lens, an optical disc, an optical fiber, an optical sheet or the like.

EP 0 482 572 describes a cured resin for high-refraction lenses is disclosed, which is obtained by polymerizing a composition comprising (A) from 70 to 99 parts by weight of a sulfur-containing aromatic (meth)acrylate represented by formula (I): 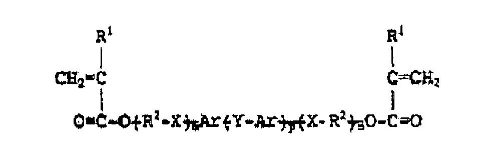 wherein R1 represents a hydrogen atom or a methyl group; R2 represents an alkylene group having from 1 to 6 carbon atoms; Ar represents an arylene group having from 6 to 30 carbon atoms, an arylene group having from 6 to 30 carbon atoms substituted with a halogen atom except a fluorine atom, an aralkylene group having from 6 to 30 carbon atoms, or an aralkylene group having from 6 to 30 carbon atoms substituted with a halogen atom except a fluorine atom; X represents -O- or -S-; Y represents -S- or -SO2- when X is -O- or Y represents -S-, -SO2-, -CO-, an alkylene group having from 1 to 12 carbon atoms, an aralkylene group having up to 12 carbon atoms, an alkylene ether group having up to 12 carbon atoms, an aralkylene ether group having up to 12 carbon atoms, an alkylene thioether group having up to 12 carbon atoms, or an aralkylene thioether group having up to 12 carbon atoms when X is -S-; m and n each represents an integer of from 1 to 5; and p represents 0 or an integer of from 1 to 10, (B) from 1 to 30 parts by weight of at least one mercapto compound selected from (B-1) a compound represented by formula (ll): 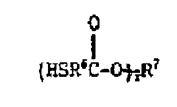 wherein R6 represents a methylene group or an ethylene group; R7 represents a hydrocarbon group having from 2 to 15 carbon atoms or an alkyl ether residue having from 2 to 15 carbon atoms; and r represents an integer of from 2 to 6, (B-2) a compound represented by formula (III): 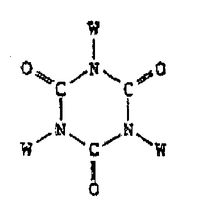 wherein W represents 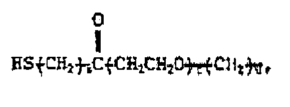 wherein s and u each represents an integer of from 1 to 8, and t represents 0 or an integer of 1 or 2, and (B-3) a compound represented by formula (IV): 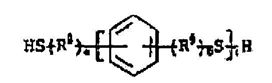 wherein R8 and R9 each represents an alkylene group having from 1 to 3 carbon atoms; a and b each represents 0 or 1; and c represents 1 or 2, and (C) up to 50 parts by weight of an ethylenically unsaturated monomer copolymerizable with the compound represented by formula (I). The resin has a high refractive index, high transparency, and excellent impact resistance.

WO 9 005 061 describes ophthalmic lens compositions comprising a cured polymer mixture of
(A) an unsaturated polyester resin composition,
(B) a monomer of formula (1); 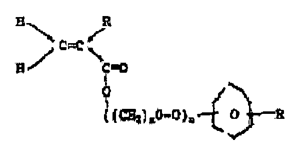
(C) an optional vinyl, acrylate monomer, or other monomer or mixtures thereof, and
(D) a free radical generating catalyst system. Such a curable plastic material can form ophthalmic lenses of superior properties including high index of refraction which reduces the amount of material required for corrections.

Especially in producing lenticular masks with the UV curing techniques, requirements on the adhesive properties are somewhat controversy: on one side, the mask should be strongly adhered to glass substrates for later application; on the other hand, however, the same mask should not adhere to the tool or moulder usually made of brass, so that the mask can be separated easily from the moulder.

### 3 Object of the invention

An object of the present invention is to provide resin compositions which have very high refractive index with moderate dispersions, have excellent technological properties so that the compositions can be treated with standard UV setups at room temperature. The masks must have very good adhesion to glass substrates and must be easily separated from the master moulder.

Especially optical products like lenticular masks require very fine geometry, excellent accuracy and precision. Surface roughness, nonlinear shrinking and deformation have a negative effect on pitch, defined by the width of the lenticulars and on the curvature of the lenticulars, which will result in lower optical quality.
The masks must have outstanding scratch resistance, chemical properties, thermal stability and no ageing tendency. Additional specifications of optical elements can be fulfilled such as being free from odour and having a smooth surface.

### 4 Description of the invention

### 4.1 Main components and preferred embodiments

The above object of the present invention can be attained by a resin composition consisting mainly of various acrylates:
a) a naphthylaliphatic acrylate,
b) an aromatic multiacrylate,
c) a multibromated aromatic acrylate,
d) and a photo initiator Pl.

In a preferred embodiment of the present invention, the resin composition contains a modified etherimide resin.

The naphthylaliphatic acrylate / naphthylaliphatic methacrylate class, especially for this purpose designed and synthesized. The Synthesis of several chosen naphthylaliphate acrylates, which will be described further in Section 6 "Syntheses of monomers", is the core part of the resin compositions. It has dominant contents, typically more than 70% and gives the basic properties of the whole composition, such as curability with UV light, transparency, and hardness of the optical plastic parts. The naphthylaliphatic groups in the molecules contribute to the very high refractive index, have anti-ageing character and keep the resin compositions in the liquid state at room temperature, which makes it possible to manufacture with UV curing techniques at room temperature.
Some members of this class, e.g. 1-naphthylethyl acrylate and 2-naphthylethyl acrylate, can be synthesized from tar by-products, which make the prices low. Specific members of this class are 2-naphthylethyl acrylate and 2-naphthylethyl methacrylate.

Mechanical properties like hardness and scratch resistance of the masks can be modified with the concentration of multiacrylate in the formulation.
Generally speaking, higher multiacrylate concentration in the resin compositions results in harder masks. Aromatic multiacrylates are used because the aromatic core in the structure gives the whole molecule properties of high refractive index. A specific member of this class is 1, 4-hydroquinone diacrylate.

The multibromated aromatic acrylate class shows generally even higher refractive indices than those of the above-mentioned two classes, i.e. the naphthylaliphatic acrylate class and the aromatic multiacrylate class. The multibromated aromatic acrylates are actually monomers with one of the highest refractive indices ever studied. They are added in the composition to raise the refractive indices. The multibromated aromatic acrylates are usually dissolved in the main component, i.e., naphthylaliphatic acrylate till slightly below the saturation, resulting in compositions still in liquid form suitable for UV curing. At those concentrations the refractive indices can be raised up to several percent.
Besides raising the refractive indices, this class has additional functions in the resin compositions: the first is to tailor the viscosity of the resin mixture. A further object is to modify the mechanical properties of the cured products. Specific members of this class are 2, 3, 4, 5, 6-pentabromophenyl acrylate and 2, 3 4, 5, 6-pentabromobenzyl methacrylate.

In general applications Pl concentration ranges from 1 to 3 weight percent. Basic content is necessary to initiate the photo induced polymerisation. Pl concentration can be used as a method to adjust the mechanical properties. This principle can of course be applied to this embodiment. Depending on the actual formulation, especially the HDA concentration, PI concentration can be accordingly modified to get the desired mechanical properties. In a preferred embodiment a radical PI is chosen, but in accordance to the composition and the percentage of epoxies the photo-initiator can be radical as well as cationic.

In order to increase viscosity and to improve the adhesion properties, a kind of modified etherimide resin is added to the compositions. A detailed description will follow in the second embodiment of this invention. This kind of resins can be practically replaced by any resins which have high viscosity and which are dissolvable in the naphthylaliphatic acrylates. Attention should be paid that upon mixing with external resins, especially those with low refractive indices (typically around 1.5), refractive indices of the final products could be decreased. Works are undertaken to increase the intrinsic viscosity of the resin compositions in order to achieve this without alien resins.

### 4.2 Additional improvements

Additional improvements relate to inventive resin-composition where
- the naphthylaliphatic acrylate can be added or replaced by any low melting monomer having a refraction-index greater than 1.58.
- the aromatic multiacrylate can be added or replaced by any multi-functional monomer with low viscosity, preferably lower than 1000 mPas.
- the multibromated aromatic acrylate is added or replaced by any monomer having a refraction-index greater than 1.7. Preferably a low melting monomer is used.
   -- any of the components naphthylaliphatic acrylate, aromatic multiacrylate or multibromated aromatic acrylate are oligomers. They can be replaced by oligomers. These acrylates themselves are not oliogomers but lather monomers Preferably the first two components are oligomers.

In addition any eutectic or near-eutectic composition of the components mentioned above is valuable with regard to processability and production environment preferably at room-temperature.

### 5 Short description of preferred embodiments

### 5.1 First embodiment

In a first preferred embodiment the resin composition is composed of four components with a weight ratio of NMA:PBPA:HDA:PI = 100:20:2.5:1, where NMA is 1-naphthylmethyl acrylate, PBPA is 2,3,4,5,6-pentabromophenyl acrylate, HDA is 1,4-hydroquinone diacrylate and PI is photo-initiator Lucirin LPO-T from BASF.

In the formulation of this embodiment, NMA is the main component. Its weight ratio is set at 100 and weight percents of other components are optimised to NMA. PBPA functions as a kind of high index ingredient added to the formulation. The maximal solubility of PBPA in NMA is around 25 mass-percent at room temperature. In order to avoid crystallization of PBPA because of super-saturation, which may take place as a result of concentration and temperature fluctuations, concentration of PBPA in NMA is set to 20% (i.e., 20 weight parts of PBPA in 100 weight parts of NMA), somewhat below the saturation.

The effects of HDA on mechanical properties of the resulting polymer products are rather strong. In other words, small changes in HDA concentrations can result in large alterations of the polymers. Formulations without HDA give usually soft films which are mechanically sensitive for applications such as lenticular masks where accuracy in geometry is highly required. Addition of 1% HDA in the formulation produces much harder films. Too high HDA concentrations in the recipe should, nevertheless, be avoided because that the resulting products can be very brittle and susceptible of cracks and internal stress.

As results of elliposometry and refractometer measurements, polymer films from UV curing of the above mentioned resin compositions show typical refractive indices at the wave length 589.2nm (nD) of 1.6506 and corresponding Abbé numbers are typically 26.1. The refractive indices are much higher than those of industry available optical plastics, which lay around 1,61.

Besides very high refractive indices, this resin composition has other three main advantages as compared to conventional available resins. The fist advantage is that the resin composition is in liquid form at room temperature and can be cured easily by conventional UV curing setups. The liquid form makes it possible that UV curing techniques can be applied. Products of almost any geometrical form can be manufactured, in case the corresponding moulder is available. Most of the industrial optical plastics are, on the other hand, polymers or oligomers. They are generally in solid form or have very high viscosity. Techniques such as inject moulding or hot embossing are employed. Linked with these polymers and techniques are at least partially birefringent, anisotropic optical parts.

The second feature of the present embodiment lays in temperature differences a resin undergoes during a manufacture cycle. For techniques such as inject moulding or hot embossing, the resin has to be heated at least close to or even above its melting point The temperature differences during the manufacture cycle may cause distorted and curved parts as well as substantially shrinking of the products. Especially optical products like lenticular masks require very fine geometry, excellent accuracy and precision. Surface roughness, nonlinear shrinking and deformation have a negative effect on pitch, defined by the width of the lenticulars and on the curvature of the lenticulars, which will result in lower optical quality.

For UV curing with liquid resins, all required processes and production-steps take place at room temperatures. The temperature effects are, therefore, not significant.

The third characteristic of the present embodiment deals with the realization of the final product: whether they are thermoplastic (linear polymers) or thermosetting (cross-linking networks). To realize this, it is an easy step in UV curing just to decide whether multi-functioned components are added or not added to the formulations. When all the components are single functioned, the final products are thermoplastic, while multi-functioned components result in thermosetting products.
On the other hand, in order to employ techniques such as inject moulding or hot embossing; the raw products have to be heated and melted. They are, therefore, have to be thermoplastic. Special components, steps and techniques are needed to make these final products thermosetting.

Cured films from the present embodiment are colourless transparent and have very good anti-yellowing resistance. Haze of such a film with a thickness of 1 mm is much less than 0.5%. The films are thermally stable up to 200°C. Between room temperature and 200°C, no thermal effects can be observed with DSC (differential scanning calorimeter) and no weight loss detectable with TGA (thermal gravity analysis) techniques. Cured films are typically odourless.

### 5.2 Second embodiment

In a second preferred embodiment the resin composition is composed of five components. The four components have the same weight ratio like that as described in the first embodiment, that is, NMA:PBPA:HDA:PI = 00:20:2.5:1. The fifth component, coded EXP04215 from Brewer Science Inc., is a high index resin with high viscosity. This resin functions in the formulation to increase the viscosity in order for easier controlling of rheological properties and for a better spreading of the composition on the moulder. Another function of EXP04215 is to better the adhesion between the polymer film and the glass substrate. 23 weight portions (in relation to 100 weight portion of NMA) of EXP04215 were added to the resin composition.
Due to the intrinsic high index property of EXR04215, there is not much loss on refractive index of the resulting polymer films. The refractive index nD is 1.6492 and the corresponding Abbé number is 23.3.
Other optical, mechanical, thermal and chemical properties of the resin composition are similar to those of the above mentioned first embodiment.

### 6 Syntheses of monomers

### 6.1 Synthesis of 1-naphthylethyl acrylate-(NEA)

### 6.1.1 Chemicals

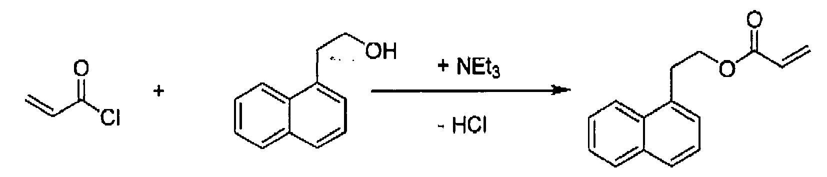

Acryloyl chloride was distilled before use. Triethylamine was refluxed over calcium hydride and then distilled. 1-Naphthalene ethanol was used as received. All chemical and solvents were purchased from Aldrich or Fluka.

### 6.1.2 Synthesis steps

Solution A: 50.3g (0.29mol) 1-naphthlene ethanol, 50ml (0.359mol) triethylamine were dissolved under inert gas in a 2-Litre flask in 450ml dry dichloromethane, yielding a yellow solution which was cooled with ice/salt to about -4°C.

Solution B: 30ml (0,369mol) acryloyl chloride was dissolved in a 250ml dropping funnel in 100ml dry dichloromethane and the funnel was locked up with a dry tube.

Under inert gas, stirring and ice/salt cooling, solution B was dropped slowly into solution A in about 3 to 4 hours. The yellowish, turbid mixture was then stirred at room temperature overnight.

The white triethylamine-hydrochloric acid salt, which floated over the yellowish-clear solution, was separated from the solution with a Büchner funnel. The solution was washed 5 times with 200ml 5% sodium hydrogen carbonate solution and then 4 times with 200ml water. The organic phase was dried with magnesium sulphate overnight and the solvent removed with a rotation evaporator, yielding 46,23g (0.206mol) brown liquid (yield: 71%).

### 6.1.3 Purification

The raw product was purified through column chromatography with ethylester / hexan (1:7 volume) as eluent, yielding 39,34g (0,175mol) transparent colourless liquid (yield: 85.1 %). Yield of the whole synthesis is 60.4%. Refractive index of the pure product as measured with an Abbé Refractometer at the wave length 589nm is nD = 1.5873 at 21.5°C.

### 6.2 Synthesis of 1,4-hydroquinone diacrylate (HDA)

### 6.2.1 Chemicals

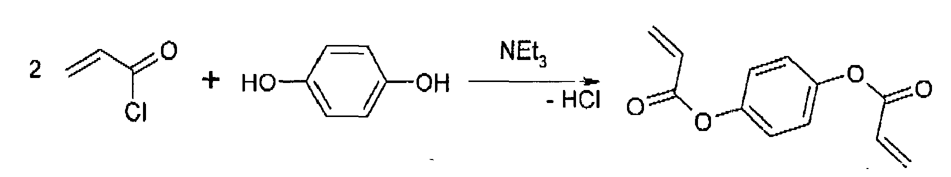

Chemicals and solvents are purchased and purified the same as those described in Section 6.1.1 "Chemicals"

### 6.2.2 Synthesis steps

Solution A: 28.14g (0.256mol) 1,4-hydroquinone, 72ml (0.512mol) triethylamine were dissolved under inert gas in a 1-Litre flask in 300ml dry dichloromethane, yielding a slightly bluish solution in which white-salt precipitation took place. The mixture was cooled with ice/salt.

Solution B: 41.6ml (0,512mol) acryloyl chloride was dissolved in a 250ml dropping funnel in 150ml dry dichloromethane and the funnel was locked up with a dry tube.

Under inert gas, stirring and ice/salt cooling, solution B was dropped slowly into solution A in about 3 to 4 hours. The yellowish, turbid mixture was then stirred at room temperature overnight.

The white triethylamine-hydrochloric acid salt, which floated over the yellowish-clear solution, was separated from the solution with a Buchner funnel. The solution was washed 3 times with 400ml 5% sodium hydrogen carbonate solution and then 3 times with 400ml water. The organic phase was dried with magnesium sulphate overnight and the solvent removed with a rotation evaporator, yielding 53.45g (0.245mol) brown solid (yield: 95.7%).

### 6.2.3 Purification

The row product was purified through recrystallization from ethanol. Typically 14 gram raw product was recrystallized from 100ml ethanol. Four cycles of recrystallizations were carried out. Yield of the first, second, third and fourth recrystallization is: 70.6%, 63.7%, 64.0%, and 64.2%, respectively. Finally pure product of white crystals was obtained. Melting point: 84-86°C.

## Claims

1. Photo-curable resins and resin compositions with very high refractive indices for application in plastic optics comprising
(a) a naphthylaliphatic acrylate or a naphthylaliphatic methacylate, typically 1-, or 2-naphthylmethyl acrylate, 1-, or 2-naphthylmethyl methacrylate, 1-, or 2-naphthylethyl acrylate, 1-, or 2-naphthylethyl methacrylate, 1-, or 2-naphthylpropyl acrylate, 1-, or 2-naphthylpropyl methacrylate, with a weight percent of 60 to 90%, preferably 70 to 80%, in the formulation.
(b) an aromatic multiacrylate or an aromatic multimethacrylate, typically 1, 4-hydroquinone diacrylate, 1, 4-hydroquinone dimethacrylate, naphthalene diacrylates or dimethacrylate (e.g., 1, 4-naphthalene diacrylate, 1, 4-naphthalene dimethacrylate, 2, 5-naphthylene diacrylate, 2,5-naphthalene dimethacrylate),
with a weight percent of 1 to 10%, preferably 2 to 5% in the formulation.
(c) a muttibromated aromatic acrylate or a multibromated aromatic methacrylate, typically 2,3,4,5,6-pentabromophenyl acrylate, 2,3,4,5,6-pentabromobenzyl acrylate, 2,3,4,5,6-pentabromophenyl methacrylate, 2,3,4,5,6-pentabromobenzyl methacrylate, 2,4,6-tribromophenyl acrylate, or 2,4,6-tribromophenyl methacrylate, with a weight percent of 10 to 30%, preferably 15 to 25% in the formulation.
(d) and a photo-initiator, with a weight percent of 0.1 to 5 %, preferably 0,5 to 1,5% in the formulation.

2. The resin composition according to claim 1 additionally comprising (e) an aromatic polyetherimides.

3. The resin composition according to claim 2 in which the aromatic polyetherimides is a product coded EXP04215 from Brewer Science Inc.

4. The resin composition according to claim 1, 2 or 3 in which any of the components (1a), (1b), (1c) are oligomers.

5. The resin composition according to claim 1, 2 or 3, where to (1 a) is added or (1a) is replaced by any low melting monomer having a refraction-index greater than 1.58

6. The resin composition according to claim 1, 2 or 3, where to (1 b) is added or (1 b) is replaced by any multi-functional monomer with low viscosity.

7. The resin composition according to claim 1, 2 or 3, where to (1c) is added or (1 c) is replaced by any low melting monomer having a refraction-index higher than 1.7

8. The resin composition according to claim 1, 2 or 3 comprising a photo-initiator is a radical and/or a cationic photo-initiator.

9. The resin composition according to claim 8, where the photo-initiator is Lucirin TPO-L or Irgacur184.

10. An optical element comprising the resin composition according to any claims 1 to 9.

11. A lenticular mask comprising the resin composition according to any one of claims 1 to 9.
